# FASCICULE DE BREVET EUROPEEN

(11) **EP 2 600 105 B1**
(45) Date de publication et mention de la délivrance du brevet: **03.06.2015**
(21) Numéro de dépôt: 12194899.6
(22) Date de dépôt: 29.11.2012
(51) Int. Cl.: G01C 19/66, H05K 1/02

(54) **Elément de cadre d'un gyroscope laser comprenant un substrat comportant des ions mobiles et une électrode.**
Rahmenelement für ein Lasergyroskop, umfassend ein Substrat, das mobile Ionen enthält, und eine Elektrode
Frame element for a laser gyroscope, comprising a substrate containing mobile ions and an electrode

(30) Priorité: 02.12.2011 FR 1103681
(43) Date de publication de la demande: 05.06.2013
(73) Titulaire: Thales, 92200 Neuilly Sur Seine (FR)
(72) Inventeur: Mary, Alexandre Charles Lucien, 86100 CHATELLERAULT (FR); Morbieu, Bertrand, 37540 ST CYR SUR LOIRE (FR)
(74) Mandataire: Brunelli, Gérald

(56) Documents cités:
- WO-A1-01/35055
- US-A- 5 098 189
- US-A- 5 432 604
- US-A- 5 856 995

## Description

La présente invention concerne un élément de cadre, réalisé dans un substrat comportant des ions mobiles, d'un gyroscope laser. Ce substrat peut être de type céramique ou métallique mais aussi de tout type de matériaux comportant des ions mobiles. Elle s'applique au domaine des équipements dont le substrat possède des ions mobiles et dont le déplacement de ces ions vers certaines zones peut fragiliser ces dites zones.

Il est connu, pour éviter ce déplacement d'ions et la fragilisation résultante, de placer une barrière isolante entre la structure contenant les ions mobiles et les zones à protéger. Il est connu, pour réaliser cette barrière isolante, l'utilisation d'une barrière diélectrique. Un tel dispositif présente le défaut de nécessiter, durant le processus de fabrication, le dépôt d'une barrière isolante.

Il est également connu d'utiliser une électrode permettant d'attirer les ions vers une zone dédiée à cet effet du substrat. Cette électrode doit être d'un potentiel différent de celui de l'anode ou de la cathode afin d'attirer les ions. Un tel dispositif présente le défaut de nécessiter l'ajout d'une autre source de tension d'un potentiel différent de celui utilisé par la ou les électrodes déjà présentes dans le gyroscope laser.

US 5 856 995 A divulgue un élément de cadre d'un gyroscope laser avec un piège à ions, US 5 432 604 A divulgue un anneau isolant entre le cadre et son dispositif de fixation.

La présente invention vise notamment à remédier à ces problèmes en proposant un dispositif permettant de protéger les zones sensibles d'un gyroscope laser de l'accumulation d'ions tout en évitant l'ajout d'une couche de protection ou d'une nouvelle source à un potentiel différent des sources utilisées par l'anode ou la cathode.

Aussi, il est proposé, selon un aspect de l'invention un élément de cadre d'un gyroscope laser comprenant un substrat présentant des ions mobiles, et une électrode fixée audit substrat, **caractérisé en ce qu'il** comprend au moins un élément électriquement conducteur, relié électriquement à ladite électrode, et muni d'au moins une partie distale intégrée audit substrat et présentant au moins une pointe et/ou au moins une rainure, formant au moins un trou borgne et/ou au moins une rainure dans ledit substrat, de forme correspondante à celle de ladite ou lesdites parties distales, pour obtenir un effet de pointe.

Ce dispositif apporte donc l'avantage de permettre l'attraction des ions mobiles par la partie distale comportant au moins un cône et/ou au moins une rainure. Cette attraction des ions mobiles résulte du potentiel plus élévé au niveau de la pointe ou de la rainure provoqué par le phénomène physique connu sous le nom d'effet pointe.

Selon un mode de réalisation de l'invention au moins une pointe présente un rayon de courbure d'une valeur inférieure au carré de la plus grande longueur de la zone du substrat à protéger, divisé par la distance minimale séparent ladite pointe et la zone du substrat à protéger.

Selon un mode de réalisation de l'invention au moins une rainure présente un rayon de courbure d'une valeur inférieure au carré de la plus grande longueur de la zone du substrat à protéger, divisé par la distance minimale séparant ladite rainure et la zone du substrat à protéger.

Dans le cas d'une surface en forme de pointe, le rayon de courbure en un point est le rayon d'une sphère tangent audit point à la dite surface. En effet, une pointe, de par la nature atomique de la matière, n'est jamais parfaitement pointue en son extrémité, mais présente une forme d'ellipse. Le rayon de courbure est alors le rayon du cercle tangent à l'extrémité de l'ellipse.

Dans le cas d'une surface en forme de rainure, le rayon de courbure en un point est le rayon d'un cylindre dont la hauteur est parrallèle à la direction de la rainure tangent audit point à la dite surface.

La plus grande longueur d'une zone correspond à la longueur maximale que puisse avoir un segment reliant deux points situés à la périphérie de la zone.

Cette caractéristique technique permet d'adapter la taille de la partie distale, en particulier la taille de la rainure ou de la pointe, à la forme du cadre du gyroscope laser et ainsi de permettre l'intégration deladite partie distale au plus proche des éléments à protéger.

Selon un mode de réalisation de l'invention ladite ou lesdites pointes ou ladite ou lesdites rainures sont à une distance de la zone du substrat à protéger inférieure à la moitié de la plus grande longueur du cadre de gyroscope laser.

La plus grande longueur d'un cadre correspond à la longueur maximale que puisse avoir un segment reliant deux points situés à la périphérie du cadre.

Ces deux caractéristiques techniques permettent d'optimiser la localisation des éléments servant à attirer les ions alcalins.

Avantageusement lequel le substrat comprend du « Zerodur » (marque déposée).

Selon un mode de réalisation de l'invention ledit ou lesdits éléments éléctriquements conducteurs et ladite ou lesdites parties distales sont adaptés pour être intégrés en surface dudit substrat de cadre de gyroscope laser.

Selon un mode de réalisation de l'invention ledit ou lesdits éléments éléctriquements conducteurs et ladite ou lesdites parties distales sont adaptés pour être intégrés à l'intérieur dudit substrat de cadre de gyroscope laser.

Cette deux caractéristiques techniques permettent d'adapter la localisation de la partie distale, en particulier la localisation de la rainure ou de la pointe, à la forme du cadre du gyroscope laser et ainsi de permettre l'intégration de la partie distale au plus proche des éléments à protéger.

Avantageusement le gyroscope laser contient un élément de cadre selon l'une des revendications précédentes.

L'invention sera mieux comprise et d'autres avantages apparaîtront à la lecture de la description détaillée faite à titre d'exemple non limitatif et à l'aide des figures parmi lesquelles :
- La figure 1 représente schématiquement un mode de réalisation du dispositif, selon un aspect de l'invention.
- La figure 2 représente schématiquement un mode de réalisation du dispositif dans lequel la partie distale comporte une rainure
- La figure 3 représente schématiquement un mode de réalisation du dispositif dans lequel la partie distale comporte plusieurs pointes
- La figure 4 représente schématiquement un mode de réalisation du dispositif dans lequel la partie distale est intégrée dans le cadre du gyroscope laser

La présente invention concerne un dispositif permettant d'attirer les ions mobiles, dont le déplacement est provoqué par un champ électrique créé par une pluralité d'électrodes, présents dans un substrat vers des zones du substrat dédiées et non fagile.

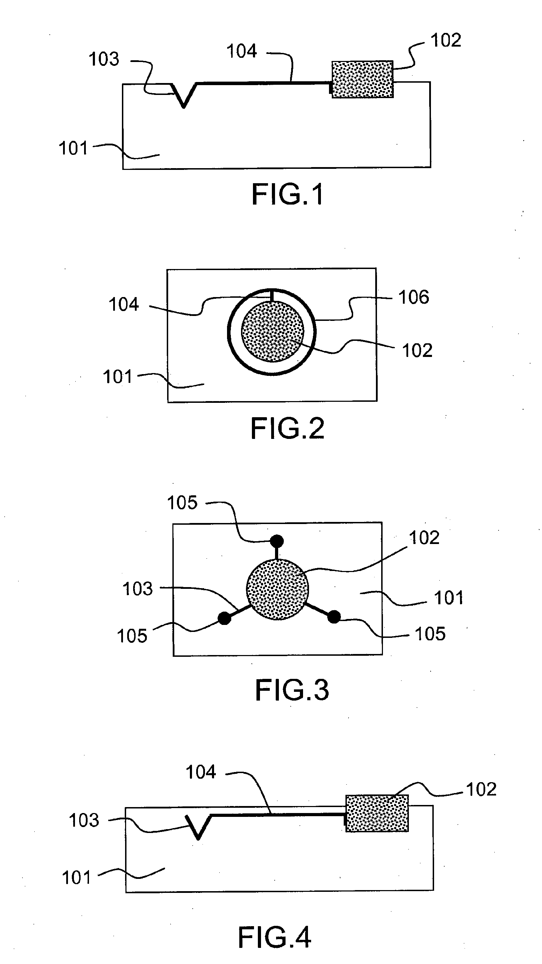

Le dispositif tel que présenté figure 1 comporte un cadre 101 de gyroscope laser réalisé dans un substrat possédant des ions mobiles. Ce substrat peut par exemple être réalisé dans le matériau connu sous le nom de « Zerodur » (marque déposée). Le gyroscope laser comporte une électrode 102. Cette électrode permet d'entretenir le faisceau laser du gyrsocope laser, mais son rôle peut-être différent dans d'autres applications. Le champ électrique produit par la ou les électrodes va avoir pour effet négatif de provoquer le déplacement des ions présents dans le substrat. Pour canaliser ce déplacement des ions vers une zone dédiée et non fragile du substrat une partie distale 103 est ajoutée à l'électrode. Cette partie distale 103 est reliée à l'électrode 102 par un élément 104 électriquement conducteur. Cet élement conducteur peut-être réalisé par le biais d'un adhésif conducteur, par dépôt métallique ou par tout autre équipement permettant de conduire l'électricité entre l'électrode et la partie distale. La partie distale présente au moins une pointe 105 et/ou au moins une rainure 106. La partie distale peut comporter un mélange de pointes et de rainures et ces pointes et rainures peuvent être placées à différents endroits dans ou à la surface du substrat afin de protéger plusieurs zones du substrat. Ces éléments permettent par le processus physique connu sous le nom d'effet pointe d'augmenter le potentiel de la partie distale par rapport au potentiel de l'électrode. Cette augmentation de potentiel va alors attirer les ions. Afin que cette augmentation de potentiel soit optimale il est préférable que le rayon de courbure à l'extrémité de la pointe ou le long de la rainure soit inférieur à M²/d (M étant la plus grande longueur de la zone du substrat à protéger et d étant la distance minimale entre la pointe et la zone du substrat à protéger). Ces pointes ou rainures forment de plus un trou borgne ou une rainure dans le substrat, de forme correspondante à celle de ladite partie distale. Afin d'améliorer les performances du système de piègeage des ions il est préférable de placer les cones ou les rainures de la partie distale à une distance inférieur à L/2 (dans cette équation L est la plus grande longueur du cadre du gyroscope laser) de la zone à protéger.

Les figures 2 à 4 présentent différents modes de réalisation du dispositif dans lesquels la localisation et la forme du dispositif de piégeage sont adaptées à la forme du cadre du gyroscope et à la zone à protéger. La figure 2 présente un mode de réalisation du dispositif dans lequel le système de piégeage comporte une rainure circulaire. La figure 3 présente un mode de réalisation du dispositif dans lequel le système de piégeage comporte trois pointes. La figure 4 présente un mode de réalisation du dispositif dans lequel le système de piégeage est intégré dans le substrat

## Revendications

1. Elément de cadre d'un gyroscope laser comprenant un substrat (101) comportant des ions mobiles et une électrode fixée (102) audit substrat, avec au moins un élément électriquement conducteur (104), muni d'au moins une partie distale (103) intégrée audit substrat **caractérisé en ce que** ledit élément électriquement conducteur est relié électriquement à ladite électrode, et qu'il présente au moins une pointe (105) et/ou au moins une rainure (106), formant au moins un trou borgne et/ou au moins une rainure dans ledit substrat, de forme correspondante à celle de ladite ou lesdites parties distales, pour obtenir un effet de pointe.

2. Elément de cadre d'un gyroscope laser selon la revendication 1 dans lequel au moins une pointe présente un rayon de courbure d'une valeur inférieure au carré de la plus grande longueur de la zone du substrat à protéger, divisé par la distance minimale séparant ladite pointe et la zone du substrat à protéger.

3. Elément de cadre d'un gyroscope laser selon la revendication 1 ou 2 dans lequel au moins une rainure présente un rayon de courbure d'une valeur inférieure au carré de la plus grande longueur de la zone du substrat à protéger, divisé par la distance minimale séparant ladite rainure et la zone du substrat à protéger.

4. Elément de cadre d'un gyroscope laser selon l'une des revendications 1 à 3 dans lequel au moins une pointe (105) et/ou au moins une rainure (106) est ou sont à une distance de la zone du substrat à protéger inférieure à la moitié de la plus grande longueur du cadre du gyroscope laser.

5. Elément de cadre d'un gyroscope laser selon l'une des revendications 1 à 4 dans lequel le substrat comprend du « Zerodur » (marque déposée).

6. Elément de cadre d'un gyroscope laser selon l'une des revendications 1 à 5, dans lequel ledit ou lesdits éléments éléctriquements conducteurs (104) et ladite ou lesdites parties distales (103) sont adaptées pour être intégrées en surface dudit substrat (101) du cadre du gyroscope laser.

7. Elément de cadre d'un gyroscope laser selon l'une des revendications 1 à 6, dans lequel ledit ou lesdits éléments éléctriquements conducteurs (104) et ladite ou lesdites parties distales (103) sont adaptés pour être intégrés à l'intérieur dudit substrat (101) du cadre du gyroscope laser.

8. Gyroscope laser contenant un élément de cadre selon l'une des revendications précédentes.

## Patentansprüche

1. Rahmenelement eines Lasergyroskops, das ein Substrat (101), das bewegliche Ionen aufweist, und eine mit mindestens einem elektrisch leitenden Element (104), das mit mindestens einem distalen, im Substrat integrierten Abschnitt (103) ausgestattet ist, am Substrat befestigte Elektrode (102) umfasst, **dadurch gekennzeichnet, dass** das elektrisch leitende Element mit der Elektrode elektrisch verbunden ist und dass es mindestens eine Spitze (105) und/oder mindestens eine Rille (106) aufweist, die mindestens Blindloch und/oder mindestens eine Rille in dem Substrat bildet, deren Form der des oder der distalen Abschnitte entspricht, um einen Spitzeneffekt zu erzielen.

2. Rahmenelement eines Lasergyroskops nach Anspruch 1, wobei mindestens eine Spitze einen Krümmungsradius mit einem Wert aufweist, der kleiner als das Quadrat der größten Länge der zu schützenden Zone des Substrats, dividiert durch den Mindestabstand, der die Spitze und die zu schützende Zone des Substrats trennt, ist.

3. Rahmenelement eines Lasergyroskops nach Anspruch 1 oder 2, wobei mindestens eine Rille einen Krümmungsradius mit einem Werts aufweist, der kleiner als das Quadrat der größten Länge der zu schützenden Zone des Substrats, dividiert durch den Mindestabstand, der die Rille und die zu schützende Zone des Substrats trennt, ist.

4. Rahmenelement eines Lasergyroskops nach einem der Ansprüche 1 bis 3, wobei sich mindestens eine Spitze (105) und/oder mindestens eine Rille (106) in einem Abstand von der zu schützenden Zone des Substrats befinden, der kleiner als die Hälfte der größten Länge des Rahmens des Lasergyroskops ist.

5. Rahmenelement eines Lasergyroskops nach einem der Ansprüche 1 bis 4, wobei das Substrat "Zerodur" (eingetragene Marke) umfasst.

6. Rahmenelement eines Lasergyroskops nach einem der Ansprüche 1 bis 5, wobei das oder die elektrisch leitenden Elemente (104) und der oder die distalen Abschnitte (103) ausgebildet sind, um in die Oberfläche des Substrats (101) des Rahmens des Lasergyroskops integriert zu sein.

7. Rahmenelement eines Lasergyroskops nach einem der Ansprüche 1 bis 6, wobei das oder die elektrisch leitenden Elemente (104) und der oder die distalen Abschnitte (103) ausgebildet sind, um im Substrat (101) des Rahmens des Lasergyroskops integriert zu sein.

8. Lasergyroskop, das ein Rahmenelement nach einem der vorangehenden Ansprüche enthält.

## Claims

1. A frame element for a laser gyroscope comprising a substrate (101), which comprises mobile ions, and an electrode (102) fixed to said substrate, with at least one electrically conducting element (104) being provided with at least one distal part (103) that is integrated into said substrate, **characterised in that** said electrically conducting element is electrically connected to said electrode, and **in that** it has at least one point (105) and/or at least one groove (106) forming at least one blind hole and/or at least one groove in said substrate and having a shape that corresponds to that of said one or more distal parts so as to obtain a point effect.

2. The frame element for a laser gyroscope according to claim 1, wherein at least one point has a curvature radius with a value that is less than the square of the greatest length of the zone of said substrate to be protected, divided by the minimum distance separating said point and the zone of said substrate to be protected.

3. The frame element for a laser gyroscope according to claim 1 or 2, wherein at least one groove has a curvature radius with a value that is less than the square of the greatest length of the zone of said substrate to be protected, divided by the minimum distance separating said groove and the zone of said substrate to be protected.

4. The frame element for a laser gyroscope according to any one of claims 1 to 3, wherein at least one point (105) and/or at least one groove (106) is/are at a distance from the zone of the substrate to be protected that is less than half the greatest length of the frame of the laser gyroscope.

5. The frame element for a laser gyroscope according to any one of claims 1 to 4, wherein the substrate comprises "Zerodur" (trademark).

6. The frame element for a laser gyroscope according to any one of claims 1 to 5, wherein said one or more electrically conducting elements (104) and said one or more distal parts (103) are adapted to be integrated into the surface of said substrate (101) of said frame of said laser gyroscope.

7. The frame element for a laser gyroscope according to any one of claims 1 to 6, wherein said one or more electrically conducting elements (104) and said one or more distal parts (103) are adapted to be integrated inside said substrate (101) of said frame of said laser gyroscope.

8. A laser gyroscope containing a frame element according to any one of the preceding claims.
